# EUROPEAN PATENT APPLICATION

(11) **EP 4 020 040 A1**
(43) Date of publication of application: **29.06.2022**
(21) Application number: 21208878.5
(22) Date of filing: 17.11.2021
(51) Int. Cl.: G02B 6/42, G02B 6/30

(54) **NOVEL CONNECTOR DESIGNS FOR PHOTONICS PACKAGING INTEGRATION**

(30) Priority: 22.12.2020 US 202017131682
(71) Applicant: INTEL Corporation, Santa Clara, CA 95054 (US)
(72) Inventor: LI, Xiaoqian, Chandler, 85248 (US); DESHPANDE, Nitin, Chandler, 85226 (US); KARHADE, Omkar, Chandler, 85248 (US); TODA, Asako, Santa Clara, 95051 (US); PRATAP, Divya, Hillsboro, 97124 (US); ZHANG, Zhichao, Chandler, 85286 (US)
(74) Representative: 2SPL Patentanwälte PartG mbB

(57) **Abstract**

Embodiments disclosed herein include photonics packages. In an embodiment, a photonics package comprises a package substrate, and a compute die over the package substrate. In an embodiment, a photonics die is also over the package substrate, and the photonics die overhangs an edge of the package substrate. In an embodiment, an integrated heat spreader (IHS) is over the compute die and the photonics die, and a fiber connector is coupled to the photonics die. In an embodiment, the fiber connector is attached to the IHS

## Description

### GOVERNMENT LICENSE RIGHTS

This invention was made with Government support under Agreement No. HR0011-19-3-0003, awarded by DARPA. The Government has certain rights in the invention.

### TECHNICAL FIELD

Embodiments of the present disclosure relate to electronic packages, and more particularly to photonics packages with optical fiber connector architectures for improved integration.

### BACKGROUND

The microelectronic industry has begun using optical connections as a way to increase bandwidth and performance. In photonics packages, an optical fiber is optically coupled to a photonics die. Generally, the optical coupling is implemented through the use of V-groove features on the photonics die. However, due to the small size and large number of optical fibers, controlling the optical fibers so that they can be properly set into the V-grooves has proved challenging. Currently, there are limited options for connection architectures that are cost effective and suitable for high volume manufacturing (HVM).

### BRIEF DESCRIPTION OF THE DRAWINGS

Figure 1A is a cross-sectional illustration of a photonics package with a fiber connector coupled to the integrated heat spreader (IHS), in accordance with an embodiment.
Figure 1B is a cross-sectional illustration of a photonics package with a fiber connector that extends through an opening through the IHS, in accordance with an embodiment.
Figure 1C is a cross-sectional illustration of the photonics package in Figure 1B that illustrates wings on the fiber connector that provides the coupling to the IHS, in accordance with an embodiment.
Figure 2A is a cross-sectional illustration of a photonics package with a fiber connector that comprises a turn to provide access to the photonics package from below, in accordance with an embodiment.
Figure 2B is a cross-sectional illustration of a photonics package with a fiber connector that comprises a turn to provide access to the photonics package from above, in accordance with an embodiment.
Figure 3A is a cross-sectional illustration of a photonics die and a fiber connector that has an L-shaped profile with a magnetic region, in accordance with an embodiment.
Figure 3B is a cross-sectional illustration of the fiber connector in Figure 3A, in accordance with an embodiment.
Figure 3C is a cross-sectional illustration of a photonics die and a fiber connector that includes a reflective surface to route optical signals vertically, in accordance with an embodiment.
Figure 4A is a cross-sectional illustration of a photonics package with a fiber connector attached to the IHS, in accordance with an embodiment.
Figure 4B is a plan view illustration of the photonics package in Figure 4A, in accordance with an embodiment.
Figure 4C is a cross-sectional illustration of the photonics package in Figure 4B along line C-C' that illustrates the fibers passing through vertical slots, in accordance with an embodiment.
Figure 5A is a plan view illustration of a photonics package with a package substrate that has a cutout with a first ledge and a second ledge for aligning a fiber connector, in accordance with an embodiment.
Figure 5B is a perspective view illustration of a portion of the photonics package illustrating one of the ledges, in accordance with an embodiment.
Figure 5C is a perspective view illustration of the fiber connector interfacing with the ledge of the package substrate, in accordance with an embodiment.
Figure 6A is a perspective view illustration of a fiber in a V-groove of a photonics die with a lens between the fiber and a spot size converter, in accordance with an embodiment.
Figure 6B is a cross-sectional illustration of the photonics die illustrating triangular shaped lenses, in accordance with an embodiment.
Figure 6C is a cross-sectional illustration of the photonics die illustrating lenses with an alternative shape, in accordance with an embodiment.
Figure 6D is a cross-sectional illustration of the photonics die showing the optical coupling between an end of the fiber and the spot size converter, in accordance with an embodiment.
Figure 6E is a plan view illustration of a photonics package with lenses in the plurality of V-grooves, in accordance with an embodiment.
Figure 7A is a cross-sectional illustration of a fiber connector with a moveable top portion, in accordance with an embodiment.
Figure 7B is a cross-sectional illustration of the fiber connector in Figure 7A with the top portion moved to engage the optical fiber, in accordance with an embodiment.
Figure 7C is a cross-sectional illustration of a fiber connector similar to the fiber connector in Figure 7B engaged with a photonics die, in accordance with an embodiment.
Figure 8 is a schematic of a computing device built in accordance with an embodiment.

### EMBODIMENTS OF THE PRESENT DISCLOSURE

Described herein are photonics packages with optical fiber connector architectures for improved integration, in accordance with various embodiments. In the following description, various aspects of the illustrative implementations will be described using terms commonly employed by those skilled in the art to convey the substance of their work to others skilled in the art. However, it will be apparent to those skilled in the art that the present invention may be practiced with only some of the described aspects. For purposes of explanation, specific numbers, materials and configurations are set forth in order to provide a thorough understanding of the illustrative implementations. However, it will be apparent to one skilled in the art that the present invention may be practiced without the specific details. In other instances, well-known features are omitted or simplified in order not to obscure the illustrative implementations.

Various operations will be described as multiple discrete operations, in turn, in a manner that is most helpful in understanding the present invention, however, the order of description should not be construed to imply that these operations are necessarily order dependent. In particular, these operations need not be performed in the order of presentation.

As noted above, there is a lack of cost effective high volume manufacturing (HVM) solutions for connecting fiber cables to V-grooves on photonics dies in photonics packages. As such, embodiments disclosed herein provide different integration architectures that allow for easier handling and assembly of photonics packages.

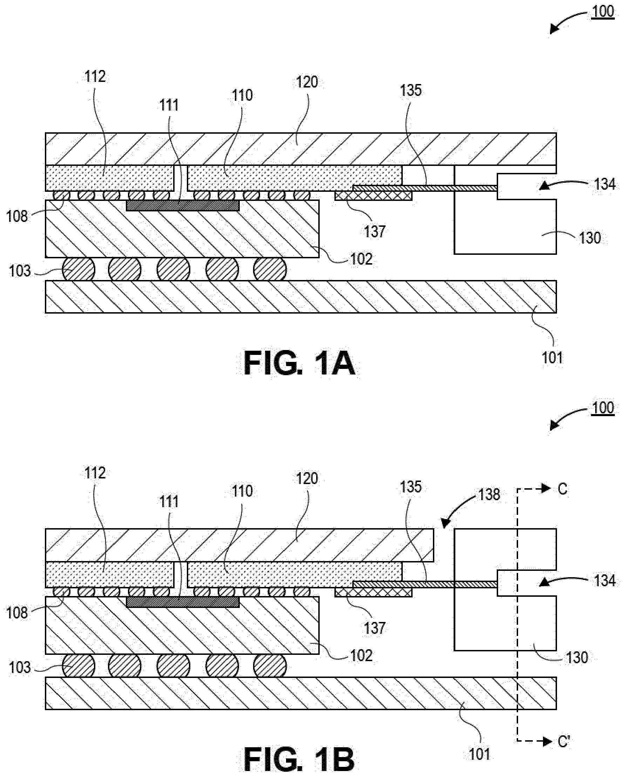

Referring now to Figure 1A, a cross-sectional illustration of a photonics package 100 is shown, in accordance with an embodiment. In an embodiment, the photonics package 100 comprises a board 101. The board 101 may be any type of board, such as, but not limited to a printed circuit board (PCB). In an embodiment, the board 101 is coupled with a package substrate 102 by interconnects 103. While shown as solder balls, it is to be appreciated that any interconnect architecture may be used to couple the package substrate 102 to the board 101, such as sockets or the like.

In an embodiment, a compute die 112 and a photonics die 110 are provided over the package substrate 102. The compute die 112 may be any type of die, such as a processor, a graphics processor, a field programmable gate array (FPGA), a system on a chip (SoC), a memory, or the like. In an embodiment, the photonics die 110 comprises functionality to convert between optical signals and electrical signals. In an embodiment, the photonics die 110 may be communicatively coupled to the compute die 112 by a bridge 111 embedded in the package substrate 102. The photonics die 110 and the compute die 112 may be coupled to the package substrate by first level interconnects (FLIs) 108. In an embodiment, the photonics die 110 may overhang an edge of the package substrate 102. The overhang of the photonics die 110 allows for access from below in order to insert optical fibers 135 into V-grooves of the photonics die 110.

In an embodiment, an integrated heat spreader (IHS) 120 is provided over the compute die 112 and the photonics die 110. The IHS 120 may be thermally coupled to the compute die 112 and the photonics die 110 by a thermal interface material (TIM) (not shown). In an embodiment, a fiber connector 130 may be attached to an underside of the IHS 120. The fiber connector 130 may include an optical fiber 135 that extends out of the fiber connector 130 towards the photonics die 110. The optical fiber 135 may be disposed in the V-groove at the edge of the photonics die 110. A lid 137 may secure the optical fiber into the V-groove. An epoxy or the like may secure the lid 137 and optical fiber 135 into the V-groove. In an embodiment, a ferrule alignment feature 134 may be provided into the fiber connector 130. The optical fiber 135 may end at the alignment feature 134.

Such an embodiment is beneficial compare to existing solutions because it provides a more compact structure. Existing solutions include a pigtail that extends away from the edge of the IHS 120, and the connector is not directly connected to the IHS 120. As such, cable management is improved, and external optical connections to the alignment feature 134 are easier to make. In the illustrated embodiment, the fiber connector 130 has a thickness that is smaller than the standoff height between the IHS 120 and the board 101. However, embodiments are not limited to such configurations.

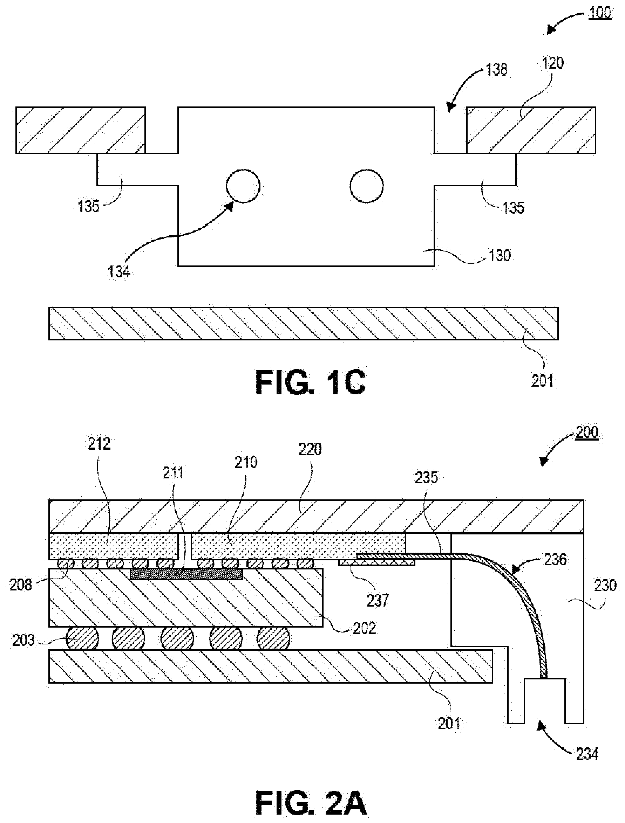

For example, as shown in Figure 1B, the IHS 120 may comprise an opening 138. The fiber connector 130 may extend up through the opening 138. In the illustrated embodiment of Figure 1B, the fiber connector 130 appears to be floating, and is not attached to anything. Figure 1C is a cross-sectional illustration along line C-C' in Figure 1B that illustrates the attachment of the fiber connector 130 to the IHS 120. As shown, the fiber connector 130 may comprise wings 135 that extend out from the edge of the fiber connector 130. In an embodiment, the wings 135 are attached to an underside surface of the IHS 120. However, it is to be appreciated that the wings 135 may also be attached to a topside surface of the IHS 120 in some embodiments. In the illustrated embodiment, a top surface of the fiber connector 130 is substantially coplanar with a top surface of the IHS 120. In other embodiments, the top surface of the fiber connector 130 may be above or below the top surface of the IHS 120.

Referring now to Figure 2A, a cross-sectional illustration of a photonics package 200 is shown, in accordance with an additional embodiment. In an embodiment, the photonics package 200 may comprise a board 201 that is coupled to a package substrate 202 by interconnects 203. A compute die 212 and a photonics die 210 are coupled to the package substrate by FLIs 208. The compute die 212 may be communicatively coupled to the photonics die 210 by a bridge 211 embedded within the package substrate 202. In an embodiment, an IHS 220 is provided over the compute die 212 and the photonics die 210.

In an embodiment, a fiber connector 230 is attached to the IHS 220. The fiber connector 230 may comprise an optical fiber 235 that extends out from the fiber connector 230 and is secured into a V-groove on the photonics die 210 by a lid 237. In an embodiment, the optical fiber 235 has a turn 236 within the fiber connector 230. In an embodiment, the turn 236 is approximately 90 degrees. A bending radius of the fiber connector 230 may be approximately 5mm in some embodiments. However, it is to be appreciated that other bending radii may be used depending on the capabilities of the optical fiber 235. Additionally, some portion or all of the optical fiber 235 within the fiber connector 230 may be replaced with an optical waveguide that can have even smaller bending radii.

As such, the fiber connector 230 allows for an external connection from below the board 201. As shown, the alignment feature 234 faces downward. This may be particularly beneficial when lateral space is constrained and connections to the photonics die 210 need to be made in the vertical direction in order to conserve real estate in the system.

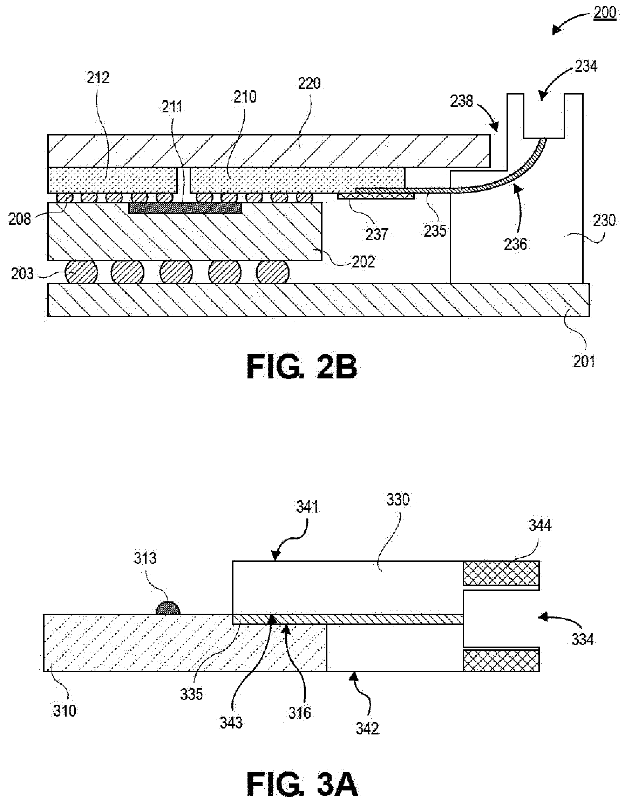

In other embodiments, the turn may be in the opposite direction. For example, in Figure 2B the turn 236 goes upward. In such an embodiment, an opening 238 through the IHS 220 may be provided in order to access the fiber connector 230 from above. As shown, the alignment feature 234 faces upward. In an embodiment, the fiber connector 230 may be attached to the board 201. In other embodiments, the fiber connector 230 may be attached to the IHS 220 by wings, similar to the embodiment shown in Figure 1C.

Referring now to Figure 3A, a cross-sectional illustration of a photonics die 310 and a fiber connector 330 is shown, in accordance with an embodiment. As shown, the fiber connector 330 is directly attached to the photonics die 310. As such, an even more compact assembly may be provided. In an embodiment, the photonics die 310 comprises a V-groove 316 in which an optical fiber 335 is placed. The optical fiber 335 may pass into the fiber connector 330 and end at an alignment feature 334. The alignment feature 334 may be surrounded by a magnetic material 344. The magnetic material 344 may be used to secure an external connection to the fiber connector 330. As such, there may not be a need for an additional latching mechanism to secure external interconnects to the fiber connector 330.

In an embodiment, the fiber connector 330 comprises a first surface 341, a second surface 342 opposite from the first surface 341, and a third surface 343 between the first surface 341 and the second surface 342. The third surface 343 may extend to an edge of the fiber connector 330. The third surface 343 may be used to press the optical fiber into the V-groove 316. In some embodiments, an epoxy or the like (not shown) is applied to secure the optical fiber 335 in the V-groove 316. A dam 313 may be provided over the photonics die 310 in order to prevent the spread of epoxy to other portions of the photonics die 310. In an embodiment, the fiber connector 330 may be referred to as having an "L-shape". The L-shape allows for the fiber connector 330 to fit over the end of the photonics die 310 and supply a surface (e.g., the third surface 335) that secures the optical fiber 335 in the V-groove 316.

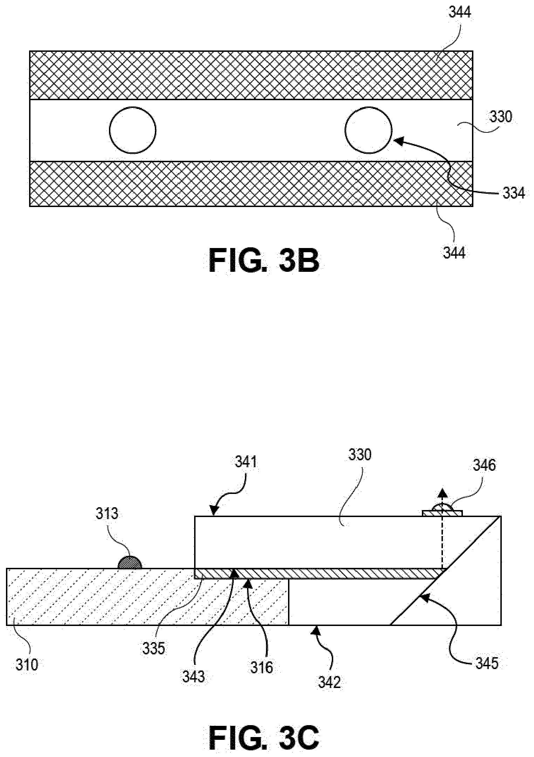

Referring now to Figure 3B, a cross-sectional illustration of the fiber connector 330 in Figure 3A is shown, in accordance with an embodiment. As shown, a plurality of alignment features 334 may be provided along a face of the fiber connector 330. Magnetic material 344 is provided above and below the plurality of alignment features 334. In some embodiments, the magnetic material 344 may wrap entirely around a perimeter of the alignment features 334. It is to be appreciated that the magnetic material 344 has minimal impact on the electrical or optical signaling. For power delivery, the impact of the magnetic material 344 may be minimized by not placing the magnet close to inductors of the integrated voltage regulators and by ensuring ground layer isolation is between the magnetic material 344 and the inductors.

Referring now to Figure 3C, a cross-sectional illustration of a photonics die 310 and a fiber connector 330 is shown, in accordance with an additional embodiment. As shown, the fiber connector 330 may comprise an L-shape that fits over an end of the photonics die 310 to secure an optical fiber 335 into a V-groove 316. That is, the fiber connector 330 may comprise a first surface 341, a second surface 342 and a third surface 343 between the first surface 341 and the second surface 342. However, in contrast to the embodiment shown in Figure 3A, the optical fiber 335 terminates at a mirror surface 345 instead of at an alignment feature 334. In an embodiment, the mirror surface 345 may be a boundary between materials with different indexes of refraction. In other embodiments, the mirror surface 345 may comprise a reflective material such as, but not limited to, silver. The mirror surface 345 may be at a 45 degree angle in order to optically couple the optical fiber 335 to a micro lens 346. The micro lens 346 may be provided over the first surface 341 of the fiber connector 330. As such, external optical coupling to the photonics die 310 may be made from above. Alternatively, the mirror surface 345 may be oriented to divert the optical signal to the bottom of the fiber connector 330. In such an embodiment, the micro lens 346 may be provided over the second surface 342. Therefore, embodiments allow for connection to the photonics die both from above and below the fiber connector 330.

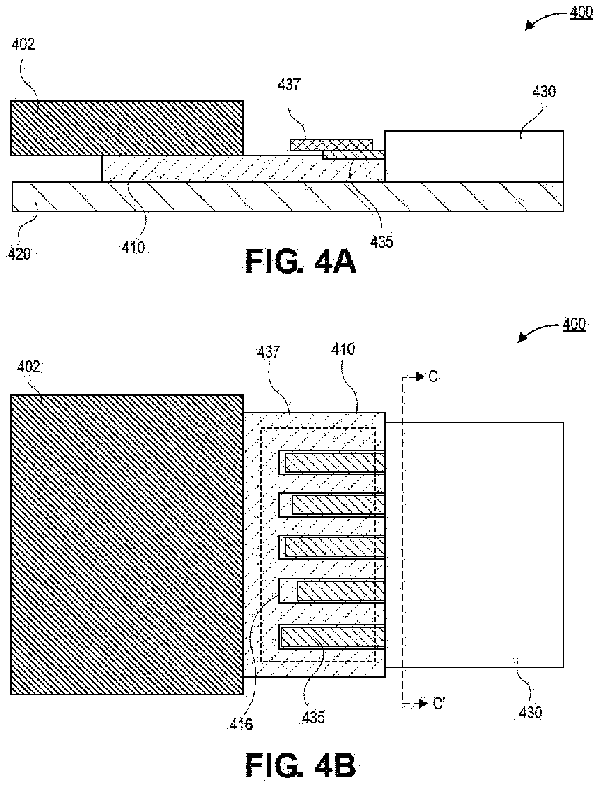

Referring now to Figures 4A-4C, a series of illustrations depicting a photonics package 400 is shown, in accordance with an additional embodiment. As shown in Figure 4A, the photonics package 400 may comprise a package substrate 402 with a photonics die 410 overhanging an edge of the package substrate 402. An IHS 420 may be provided over the photonics die 410. In an embodiment, a fiber connector 430 is attached to the IHS 420. An optical fiber 435 extends out of the fiber connector 430 and is held into a V-groove on the photonics die 410 by a lid 437.

Referring now to Figure 4B, a plan view illustration of the photonics package 400 is shown, in accordance with an embodiment. In an embodiment an array of optical fibers 435 are shown in the V-grooves 416. The overlying lid 437 is shown with a dashed line in order to not obscure the underlying optical fibers 435. As shown, the optical fibers 435 may not have uniform lengths. As such, there needs to be a feature that allows for displacement of the optical fibers 435. Without the ability to be displaced, the fiber connector 430 can only be inserted into the V-grooves up to the point where the longest optical fiber 435 contacts the end of the V-groove. This may result in the other optical fibers 435 being improperly set in the V-groove and result in poor efficiency.

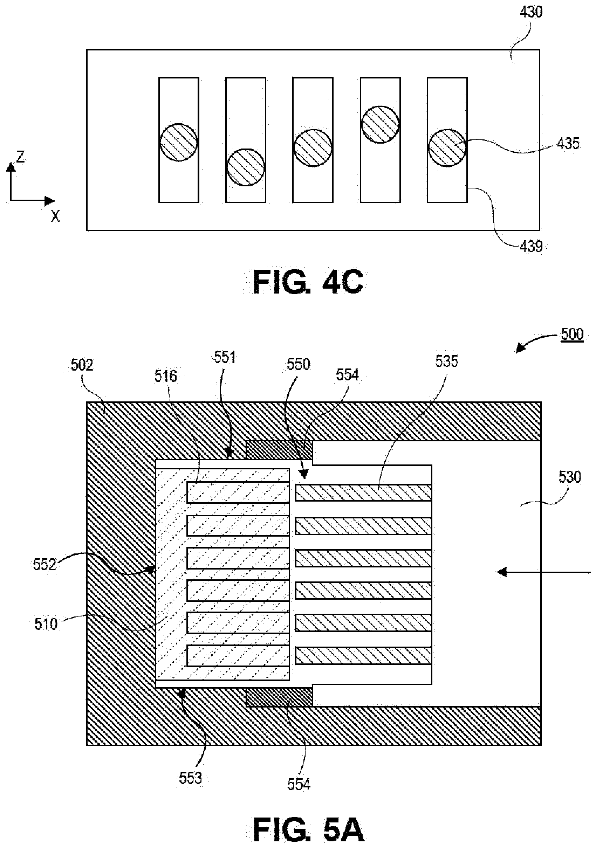

As shown in Figure 4C, which is a cross-sectional illustration of the photonics package 400 in Figure 4B along line C-C', the optical fibers 435 may be pass through vertically oriented (in the Z-direction) slots 439. The slots 439 allow for the optical fibers 435 to be displaced vertically without moving horizontally (in the X-direction). Flexibility provided by such a configuration of the fiber connector 430 allows for nonuniform length optical fibers 435 to be accommodated. When a longer optical fiber 435 reaches the end of the V-groove 416, the optical fiber is allowed to bow upwards by the slot 439 in order to allow for additional displacement of the fiber connector 430 towards the photonics die 410. Such a configuration allows for larger fiber to fiber protrusion variation, and eases assembly tolerances. Additionally, warpage or other non-uniformities within the photonics package 400 may be accommodated for without forcing the optical fibers 435 out of the V-grooves.

Referring now to Figure 5A, a plan view illustration of a photonics package 500 is shown, in accordance with an embodiment. In an embodiment the photonics package 500 comprises a package substrate 502. The package substrate 502 may include a cutout 550. The cutout 550 has a first edge 551, a second edge 552, and a third edge 553. In an embodiment, a photonics die 510 overhangs the second edge 552. V-grooves 516 are provided on the overhanging portion of the photonics die 510.

In an embodiment, the first edge 551 and the third edge 553 may comprise ledges 554. The ledges 554 are recessed surfaces. In an embodiment, the fiber connector 530 is inserted (as indicated by the arrow) into the cutout 550 and is supported by the ledges 554. In an embodiment, as the fiber connector 530 is moved toward the photonics die 510, the optical fibers 535 are inserted into the V-grooves 516.

Furthermore, it is to be appreciated that high precision package substrate assembly processes are available in the industry. That is, tolerances of approximately 1µm or lower may be provided in package substrate 502 manufacturing. The tight tolerances allow for the ledges 554 to be used as an alignment feature in order to more accurately place the optical fibers 535 into the V-grooves 516. In an embodiment, the end of the ledges 554 may also be used as a stop to prevent the optical fibers 535 from being brought into contact with an end of the V-grooves 516. In an embodiment, the fiber connector 530 may also function as a lid to partially cover the cutout 551 in the package substrate 502. This protects the fiber and V-groove region from thermal and mechanical shock, and can be used to improve reliability and durability of the photonics package 500.

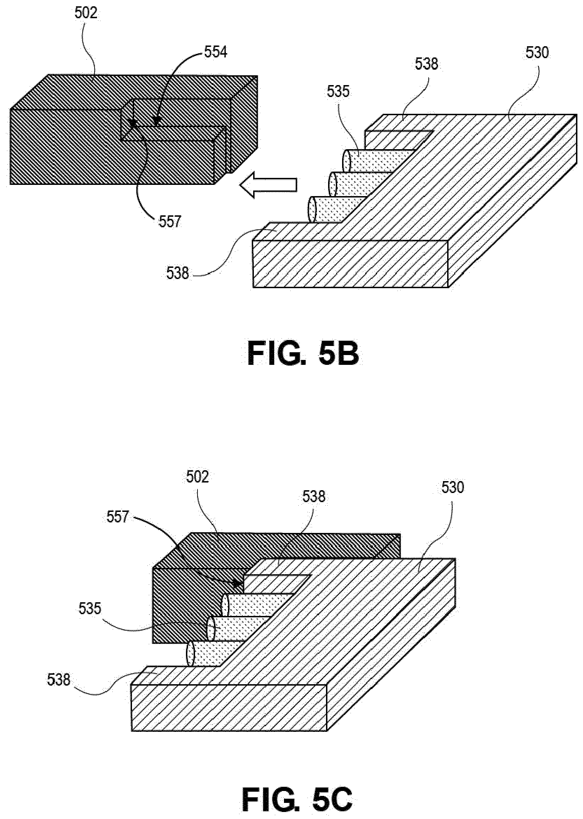

Referring now to Figure 5B and 5C, perspective view illustrations of a process for assembling the fiber connector 530 and the package substrate 502 together are shown. As shown in Figure 5B, the package substrate 502 comprises a ledge 554. The ledge 554 is a recessed surface from the top surface of the package substrate 502. In an embodiment, the ledge 554 comprises an end 557. As indicated by the arrow, the fiber connector 530 is brought towards the package substrate 502. In an embodiment, the fiber connector 530 may have protrusions 538 on each side. The protrusions 538 are aligned to interface with the ledge 554. In Figure 5B, only one side of the package substrate 502 is shown for clarity. It is to be appreciated that both protrusions 538 will interface with a ledge 554 of the package substrate 502.

Referring now to Figure 5C, a perspective view illustration of the assembled structure is shown, in accordance with an embodiment. As shown, the protrusions 538 are pushed along the ledge 554 until they contact the end 557 of the ledge 554. The end of the ledge 554 may therefore provide a stop point in order to prevent the optical fibers 535 from being pushed too far into the V-grooves of the photonics die. The photonics die and the V-grooves are omitted in Figure 5C for clarity.

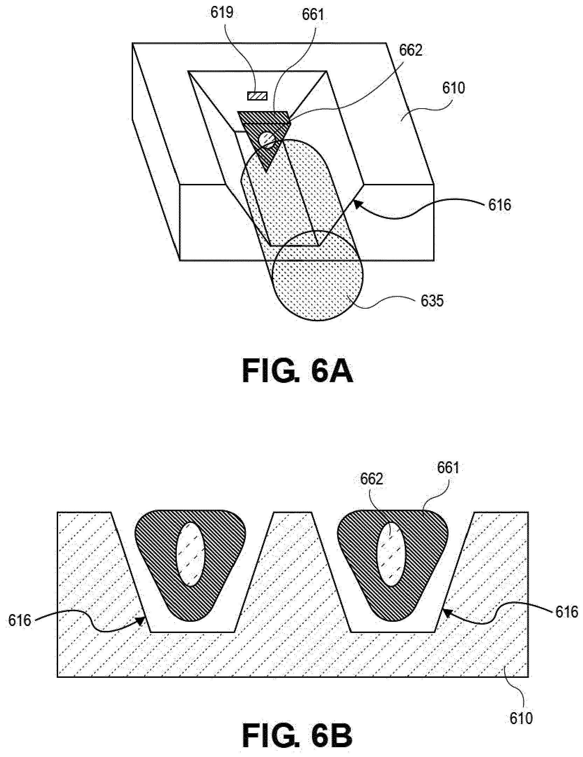

Referring now to Figure 6A, a perspective view illustration of a photonics die 610 with a V-groove 616 is shown, in accordance with an embodiment. In an embodiment, an optical fiber 635 is inserted into the V-groove 616. The optical fiber 635 may be a protrusion out from a fiber connector (not shown). The fiber connector may be similar to any of the fiber connectors described herein. In an embodiment, a lens 662 may be provided between an end of the optical fiber 635 and a spot size converter 619. The lens 662 may comprise an outer portion 661. The outer portion 661 may be shaped to interface with the V-groove 616 in order to properly orient the lens 662. In an embodiment, the lens 662 may collimate the beam for better alignment tolerance for the optical fiber 635 attachment.

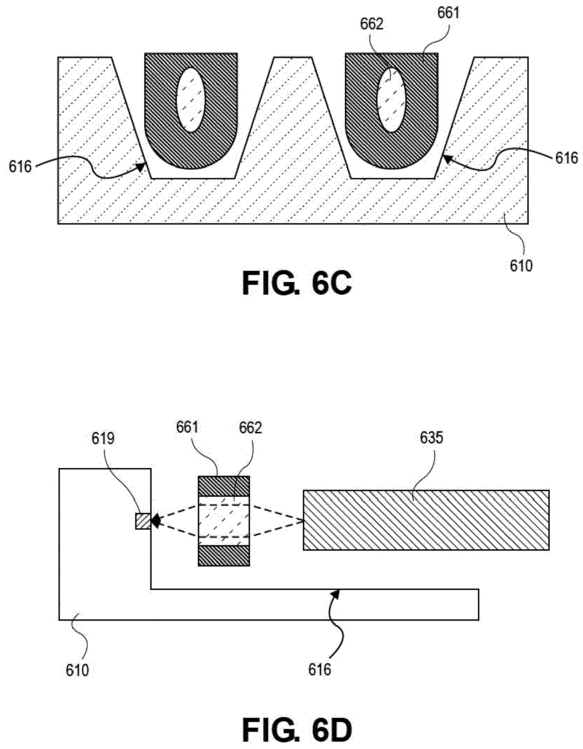

Referring now to Figure 6B, a cross-sectional illustration of the photonics die 610 through the V-grooves 616 is shown, in accordance with an embodiment. In an embodiment, the outer portion 661 may have a substantially triangular shape. In an embodiment, the triangular shape is oriented with a corner pointing down towards a bottom of the V-groove 616 and a flat edge facing upwards. Referring now to Figure 6C, a cross-sectional illustration of the photonics die 610 through the V-grooves 616 is shown, in accordance with an additional embodiment. As shown in Figure 6C, a bottom surface of the outer portion 661 may be a curved shape instead of a point of a triangle.

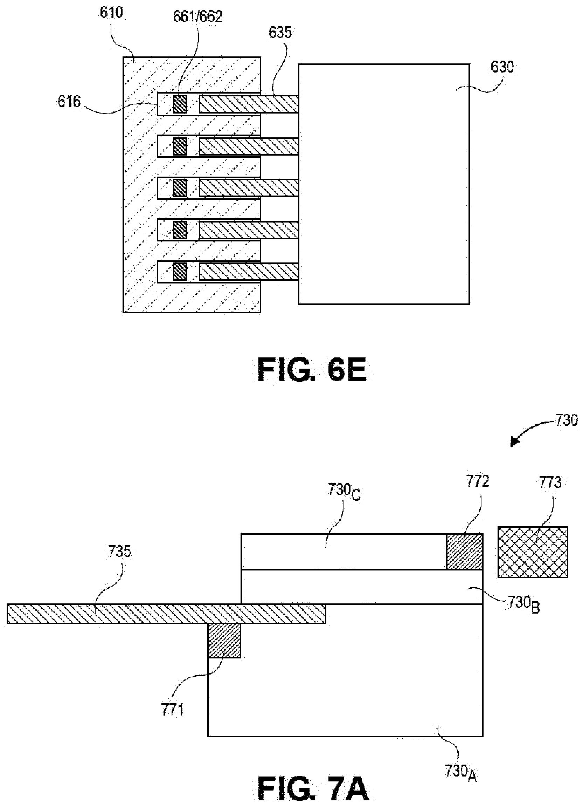

Referring now to Figure 6D, a cross-sectional illustration of the photonics die 610 along the length of the V-groove 616 is shown, in accordance with an embodiment. As shown, the light from the end of the optical fiber 635 is collimated and focused onto the spot size converter 619 by the lens 662. The presence of the lens 662 allows for there to be a greater tolerance between the end of the optical fiber 635 and the spot size converter 619. For example, in the plan view illustration shown in Figure 6E, there is a large fiber to fiber protrusion variation. Despite the large variation in the distances between the ends of the optical fibers 635 and the end of the V-grooves 616, high efficiency is provided due to the presence of the lenses 661/662. In yet another embodiment, the optical fiber 635 may be omitted. In such embodiments, the lens 662 collimates the beam to a parallel beam with a wider beam size. An external pluggable lens connector (not shown) can then be used to focus the beam back into an optical fiber that is external to the system shown in Figure 6D.

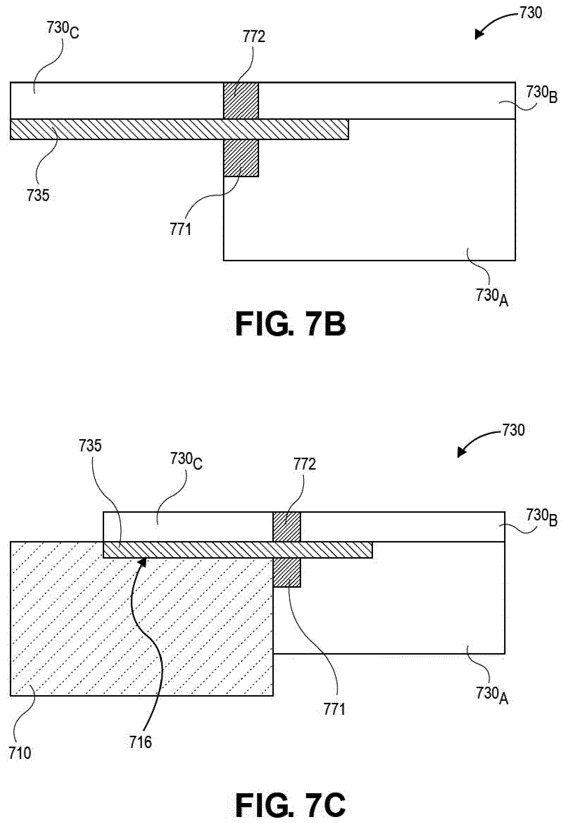

Referring now to Figures 7A-7C, cross-sectional illustrations depicting a fiber connector 730 are shown, in accordance with an embodiment. Figures 7A and 7B are illustrations of the fiber connector 730 in various configurations, and Figure 7C is a cross-sectional illustration of the fiber connector interfacing with a photonics die.

Referring now to Figure 7A, a cross-sectional illustration of a fiber connector 730 is shown, in accordance with an embodiment. The fiber connector 730 may comprise a base layer 730_{A}. An intermediate layer 730_{B} is provided over the base layer 730_{A}. In an embodiment, an optical fiber 735 extends into the base layer 730_{A} below the intermediate layer 730_{B}. The fiber connector 730 may comprise a first magnetic region 771 below the optical fiber 735. The first magnetic region 771 may be at a corner of the base layer 730_{A}. In an embodiment, a moveable top layer 730_{C} may be provided over the intermediate layer 730_{B}. The moveable top layer 730c may be displaceable relative to the intermediate layer 730_{B}. In an embodiment, a second magnetic region 772 may be provided on the moveable top layer 730_{C}. The second magnetic region 772 may be at an edge of the moveable top layer 730_{C}. In an embodiment, an external magnet 773 may be positioned proximate to the second magnetic region 772 to temporarily prevent movement of the moveable top layer 730_{C} during the fiber attach process. The external magnet 773 may not be part of the fiber connector 730 in some embodiments. In other embodiments, the external magnet 773 may be integrated as part of the fiber connector 730.

Referring now to Figure 7B, a cross-sectional illustration of the fiber connector 730 after the moveable top layer 730_{C} is moved to cover the exposed top surface of the optical fiber 735 is shown, in accordance with an embodiment. In an embodiment, the second magnetic region 772 is brought over the first magnetic region 771 in order to affix the top moveable layer 730_{C} so that it is adjacent to the intermediate layer 730_{B}.

Referring now to Figure 7C, a cross-sectional illustration of the fiber connector 730 attached to a photonics die 710 is shown, in accordance with an embodiment. As shown, the optical fiber 735 is inserted into a V-groove 716 in the photonics die 710. The moveable top layer 730_{C} is clamped down by the force between the first magnetic region 771 and the second magnetic region 772 in order to secure the optical fiber 735 in the V-groove 716.

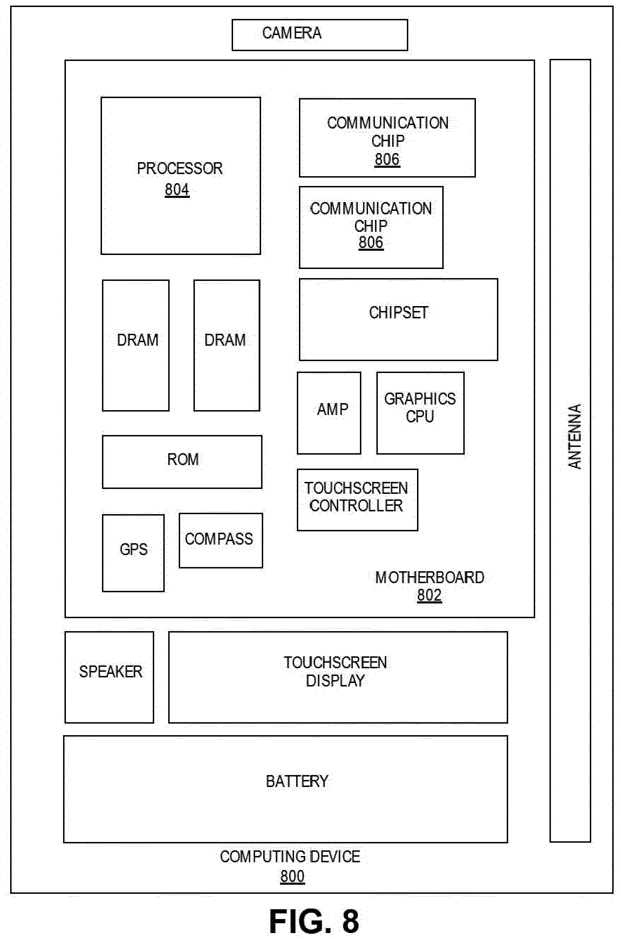

Figure 8 illustrates a computing device 800 in accordance with one implementation of the invention. The computing device 800 houses a board 802. The board 802 may include a number of components, including but not limited to a processor 804 and at least one communication chip 806. The processor 804 is physically and electrically coupled to the board 802. In some implementations the at least one communication chip 806 is also physically and electrically coupled to the board 802. In further implementations, the communication chip 806 is part of the processor 804.

These other components include, but are not limited to, volatile memory (e.g., DRAM), non-volatile memory (e.g., ROM), flash memory, a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth).

The communication chip 806 enables wireless communications for the transfer of data to and from the computing device 800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 806 may implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing device 800 may include a plurality of communication chips 806. For instance, a first communication chip 806 may be dedicated to shorter range wireless communications such as Wi-Fi and Bluetooth and a second communication chip 806 may be dedicated to longer range wireless communications such as GPS, EDGE, GPRS, CDMA, WiMAX, LTE, Ev-DO, and others.

The processor 804 of the computing device 800 includes an integrated circuit die packaged within the processor 804. In some implementations of the invention, the integrated circuit die of the processor may be part of a photonics package with a fiber connector to connect optical fibers into V-grooves in a photonics die, in accordance with embodiments described herein. The term "processor" may refer to any device or portion of a device that processes electronic data from registers and/or memory to transform that electronic data into other electronic data that may be stored in registers and/or memory.

The communication chip 806 also includes an integrated circuit die packaged within the communication chip 806. In accordance with another implementation of the invention, the integrated circuit die of the communication chip may be part of a photonics package with a fiber connector to connect optical fibers into V-grooves in a photonics die, in accordance with embodiments described herein.

The above description of illustrated implementations of the invention, including what is described in the Abstract, is not intended to be exhaustive or to limit the invention to the precise forms disclosed. While specific implementations of, and examples for, the invention are described herein for illustrative purposes, various equivalent modifications are possible within the scope of the invention, as those skilled in the relevant art will recognize.

These modifications may be made to the invention in light of the above detailed description. The terms used in the following claims should not be construed to limit the invention to the specific implementations disclosed in the specification and the claims. Rather, the scope of the invention is to be determined entirely by the following claims, which are to be construed in accordance with established doctrines of claim interpretation.
Example 1: a photonics package, comprising: a package substrate; a compute die over the package substrate; a photonics die over the package substrate, wherein the photonics die overhangs an edge of the package substrate; an integrated heat spreader (IHS) over the compute die and the photonics die; and a fiber connector coupled to the photonics die, wherein the fiber connector is attached to the IHS.
Example 2: the photonics package of Example 1, wherein the IHS comprises an opening, and wherein the fiber connector extends through the opening.
Example 3: the photonics package of Example 2, wherein the fiber connector comprises wings, wherein the wings are attached to the IHS.
Example 4: the photonics package of Examples 1-3, wherein a fiber in the fiber connector is turned approximately 90 degrees.
Example 5: the photonics package of Example 4, wherein the fiber is turned down, or wherein the fiber is turned up.
Example 6: the photonics package of Examples 1-5, wherein a plurality of fibers pass through a plurality of slots in the fiber connector.
Example 7: the photonics package of Example 6, wherein the slots are vertically oriented to allow for displacement of the plurality of fibers in a vertical direction while being substantially restrained in a horizontal direction.
Example 8: the photonics package of Examples 1-7, wherein the fiber connector comprises a plurality of fibers, wherein the photonics die comprises a plurality of V-grooves, and wherein individual ones of the plurality of fibers are inserted into individual ones of the plurality of V-grooves.
Example 9: the photonics package of Example 8, further comprising a plurality of lenses, wherein individual ones of the plurality of lenses are provided in individual ones of the V-grooves between an end of the V-groove and an end of the fiber.
Example 10: the photonics package of Example 9, wherein individual ones of the plurality of lenses comprise a triangular shaped outer housing and a convex lens within the triangular shaped housing.
Example 11: the photonics package of Examples 1-10, further comprising: a board attached to the package substrate.
Example 12: a fiber connector, comprising: a fiber housing, wherein the fiber housing comprises a first surface, a second surface opposite from the first surface, and a third surface between the first surface and the second surface; and a fiber on the third surface and extending into a body of the fiber housing.
Example 13: the fiber connector of Example 12, further comprising: an alignment hole in the fiber housing, wherein the fiber ends at the alignment hole.
Example 14: the fiber connector of Example 13 wherein the alignment hole is surrounded by a magnetic material.
Example 15: the fiber connector of Examples 12-14, further comprising: a reflective surface in the fiber housing, wherein the fiber terminates at the reflective surface.
Example 16: the fiber connector of Example 15, further comprising: a micro lens on the first surface, wherein the micro lens is optically coupled to the fiber by the reflective surface.
Example 17: the fiber connector of Examples 12-16, wherein the fiber connector is attached to a photonics die, and wherein the third surface presses the fiber into a V-groove in the photonics die.
Example 18: a photonics package, comprising: a package substrate, wherein the package substrate comprises a cutout, wherein the cutout comprises a first edge, a second edge, and a third edge, and wherein a first ledge is provided on the first edge and a second ledge is provided on the third edge; a photonics die on the package substrate, wherein the photonics die overhangs the second edge of the cutout, and wherein the photonics die comprises a plurality of V-grooves; a fiber connector comprising a plurality of fibers, wherein the fiber connector is supported by the first ledge and the second ledge.
Example 19: the photonics package of Example 18, wherein the plurality of fibers are inserted into the plurality of V-grooves.
Example 20: the photonics package of Example 18 or Example 19, wherein the fiber connector is abutted up against an end of the first ledge and an end of the second ledge.
Example 21: the photonics package of Examples 18-20, wherein a depth of the first ledge and the second ledge is substantially equal to a thickness of the fiber connector.
Example 22: the photonics package of Examples 18-21, wherein the photonics die is provided on a first surface of the package substrate, and wherein the first ledge and the second ledge are provided on a second surface of the package substrate opposite from the first surface.
Example 23: a fiber connector, comprising: a base substrate, wherein a first magnet is provided at a corner of the base substrate; an optical fiber over the base substrate; an intermediate substrate over the base substrate, wherein an edge of the intermediate substrate is adjacent to, but not over, the first magnet; and a moveable top substrate over the intermediate substrate, wherein a second magnet is provided in the moveable top substrate.
Example 24: the fiber connector of Example 23, wherein the moveable top substrate is displaceable to be adjacent to the intermediate substrate, wherein the first magnet and the second magnet secure the moveable top substrate to the base substrate.
Example 25: the fiber connector of Example 23 or Example 24, wherein a thickness of the moveable top substrate is substantially equal to a thickness of the intermediate substrate.

## Claims

1. A photonics package, comprising:
a package substrate;
a compute die over the package substrate;
a photonics die over the package substrate, wherein the photonics die overhangs an edge of the package substrate;
an integrated heat spreader (IHS) over the compute die and the photonics die; and
a fiber connector coupled to the photonics die, wherein the fiber connector is attached to the IHS.

2. The photonics package of claim 1, wherein the IHS comprises an opening, and wherein the fiber connector extends through the opening.

3. The photonics package of claim 2, wherein the fiber connector comprises wings, wherein the wings are attached to the IHS.

4. The photonics package of claim 1, 2 or 3, wherein a fiber in the fiber connector is turned approximately 90 degrees.

5. The photonics package of claim 4, wherein the fiber is turned down, or wherein the fiber is turned up.

6. The photonics package of claim 1, 2, 3, 4 or 5, wherein a plurality of fibers pass through a plurality of slots in the fiber connector.

7. The photonics package of claim 6, wherein the slots are vertically oriented to allow for displacement of the plurality of fibers in a vertical direction while being substantially restrained in a horizontal direction.

8. The photonics package of claim 1, 2, 3, 4, 5, 6 or 7, wherein the fiber connector comprises a plurality of fibers, wherein the photonics die comprises a plurality of V-grooves, and wherein individual ones of the plurality of fibers are inserted into individual ones of the plurality of V-grooves.

9. The photonics package of claim 8, further comprising a plurality of lenses,
wherein individual ones of the plurality of lenses are provided in individual ones of the V-grooves between an end of the V-groove and an end of the fiber.

10. The photonics package of claim 9, wherein individual ones of the plurality of lenses comprise a triangular shaped outer housing and a convex lens within the triangular shaped housing.

11. A method of fabricating a photonics package, the method comprising:
coupling a compute die and a package substrate;
coupling a photonics die and the package substrate, wherein the photonics die overhangs an edge of the package substrate;
coupling an integrated heat spreader (IHS) and the package substrate, the IHS over the compute die and the photonics die; and
coupling a fiber connector to the photonics die, wherein the fiber connector is attached to the IHS.

12. The method of claim 11, wherein the IHS comprises an opening, and wherein the fiber connector extends through the opening.

13. The method of claim 12, wherein the fiber connector comprises wings, wherein the wings are attached to the IHS.

14. The method of claim 11, 12 or 13, wherein a fiber in the fiber connector is turned approximately 90 degrees.

15. The method of claim 14, wherein the fiber is turned down, or wherein the fiber is turned up.
